# EUROPÄISCHE PATENTANMELDUNG

(11) **EP 4 586 761 A1**
(43) Veröffentlichungstag der Anmeldung: **16.07.2025**
(21) Anmeldenummer: 25150829.7
(22) Anmeldetag: 09.01.2025
(51) Int. Cl.: H10D 1/00, H01L 21/02, H10D 1/66

(54) **VERFAHREN ZUR HERSTELLUNG EINER GRABENKONDENSATORSTRUKTUR UND GRABENKONDENSATOR**

(30) Priorität: 10.01.2024 DE 102024200211
(71) Anmelder: Fraunhofer-Gesellschaft zur Förderung der angewandten Forschung e.V., 80686 München (DE)
(72) Erfinder: Becker, Tom, 91058 Erlangen (DE); Erlbacher, Tobias, 91099 Poxdorf (DE)
(74) Vertreter: Hersina, Günter

(57) **Zusammenfassung**

Verfahren zur Herstellung einer Grabenkondensatorstruktur umfassend die Schritte Bereitstellen eines Siliziumsubstrats (210) mit einer Grabenstruktur mit einer Mehrzahl von Vertiefungen in einer Hauptoberfläche des Siliziumsubstrats; Bilden einer ersten Siliziumdioxidschicht (2201) zumindest in den Vertiefungen des Siliziumsubstrats; Aufbringen einer ersten Siliziumnitridschicht (2301) auf der ersten Siliziumdioxidschicht; Aufbringen einer zweiten Siliziumdioxidschicht (2202) auf der ersten Siliziumnitridschicht durch Aufbringen einer polykristalinen Siliziumschicht (222) und Oxidieren der polykristalinen Siliziumschicht; und Aufbringen einer zweiten Siliziumnitridschicht (2302) auf der zweiten Siliziumdioxidschicht.

## Beschreibung

Ausführungsbeispiele gemäß der Erfindung beziehen sich auf ein Verfahren zur Herstellung einer Grabenkondensatorstruktur und auf einen Grabenkondensator, bzw. auf ein Verfahren zur Herstellung eines dielektrischen Schichtstapels und auf einen Grabenkondensator mit einem dielektrischen Schichtstapel. Bei dem dielektrischen Schichtstapel handelt es sich vorzugsweise um einen dielektrischen (ON)ₓ-Stapel mit x≥2 zum Beispiel für Si-RC Snubberbauelemente, wobei eine Siliziumdioxidschicht mit O bezeichnet ist und eine Siliziumnitridschicht mit N bezeichnet ist.

Es sind unterschiedliche Konzepte zur Reduktion der Substratverbiegung bei der Herstellung eines integrierten Kondensators bekannt.

Das Patent DE102019204503B3 offenbart beispielsweise die Einführung einer stressfreien Nitridschicht zur Erhöhung der Spitzenspannungsfestigkeit auf 1200 V und der Reduzierung der Scheibenverbiegung. Eine weitere Erhöhung der Spannungsfestigkeit ist bei einer derartigen Bauart aber kaum möglich, ohne Integrationsdichte zu verlieren (z.B.: durch dickere dielektrische Schichten) oder die Waferverbiegung drastisch zu erhöhen (z.B.: dickere dielektrische Schichten bei gleichzeitiger Erhöhung der Oberfläche durch tiefere Lochstrukturierung).

In Anbetracht dessen besteht ein Bedarf nach einem Konzept für Bauelemente mit Dielektrikum, z. B. Grabenkondensatoren oder RC-Snubber, oder für dielektrische Schichtstrukturen zur Erhöhung einer Durchbruchspannung bei gleichbleibender oder erhöhter Integrationsdichte (Kapazität) unter Berücksichtigung der Scheibenverbiegung durch thermomechanischen Stress bei/nach der Abscheidung der dielektrischen Schichten.

Diese Aufgabe wird durch die Gegenstände der unabhängigen Patentansprüche gelöst. Erfindungsgemäße Weiterbildungen sind in den Unteransprüchen definiert.

### Zusammenfassung der Erfindung

Gemäß einem Aspekt der vorliegenden Erfindung haben die Erfinder erkannt, dass ein Problem bei der Herstellung einer Grabenkondensatorstruktur darin besteht, dass eine Spannungsfestigkeit kaum erhöht werden kann, ohne die Integrationsdichte zu verlieren oder die Verbiegung des Siliziumsubstrats drastisch zu erhöhen. Gemäß einem Aspekt der vorliegenden Erfindung wird diese Schwierigkeit überwunden, indem in einer Grabenstruktur eines Siliziumsubstrats ein dielektrischer Schichtstapel aus zumindest zwei Siliziumdioxidschichten und zumindest zwei Siliziumnitridschichten bereitgestellt wird, bei dem die Siliziumdioxidschichten und die Siliziumnitridschichten abwechselnd übereinander angeordnet sind. Mit Grabenkondensatoren kann im Vergleich zu planaren Kondensatoren zwar eine höhere Kapazitätsdichte erzielt werden, aber gleichzeitig muss beachtet werden, dass Fertigungsmechanismen für planare Kondensatoren nicht einfach auf Grabenkondensatoren angewendet werden können, insbesondere da das Beschichten von Grabenstrukturen ganz anderen Herausforderungen, z. B. im Zusammenhang mit gleichmäßigen Schichtdicken und Substratverbiegungen, standhalten muss als eine Beschichtung planarer Flächen. In diesem Zusammenhang haben die Erfinder erkannt, dass durch die abwechselnde Bildung von Siliziumdioxidschichten und Siliziumnitridschichten in Grabenstrukturen nicht nur eine Substratverbiegung während der Bildung des Schichtstapels kontrolliert werden kann, sondern es ferner ermöglicht wird, dass eine Lochtiefe und damit die Oberflächenvergrößerung des Kondensators erhöht werden kann. Dabei wurde insbesondere festgestellt, dass der in der Grabenstruktur gebildete Schichtstapel zumindest zwei Siliziumdioxidschichten und zumindest zwei Siliziumnitridschichten aufweisen muss, um die Substratverbiegung bei großen Lochtiefen so gering wie möglich zu halten. Ferner wurde beobachtet, dass in Zusammenhang mit Grabenstrukturen eine Siliziumdioxidschicht auf einer Siliziumnitridschicht besonders vorteilhaft gebildet werden kann, d. h. mit hoher Qualität, wie z. B. mit gleichmäßiger Struktur, mit gleichmäßiger Schichtdicke und/oder Defektarm, wenn eine polykristaline Siliziumschicht aufgebracht wird und diese oxidiert wird. Somit können Grabenkondensatorstruktur mit einem dielektrischen Schichtstapel mit hoher Durchbruchfestigkeit erhalten werden.

Dementsprechend betrifft ein Ausführungsbeispiel ein Verfahren zur Herstellung einer Grabenkondensatorstruktur. Das Verfahren umfasst ein Bereitstellen eines Siliziumsubstrats mit einer Grabenstruktur mit einer Mehrzahl von Vertiefungen in einer Hauptoberfläche des Siliziumsubstrats. Ferner umfasst das Verfahren ein Bilden einer ersten Siliziumdioxidschicht in den Vertiefungen des Siliziumsubstrats; ein Aufbringen einer ersten Siliziumnitridschicht auf der ersten Siliziumdioxidschicht; ein Aufbringen einer zweiten Siliziumdioxidschicht auf der ersten Siliziumnitridschicht durch Aufbringen einer polykristalinen Siliziumschicht und Oxidieren der polykristalinen Siliziumschicht; und ein Aufbringen einer zweiten Siliziumnitridschicht auf der zweiten Siliziumdioxidschicht. Die erste Siliziumdioxidschicht wird zumindest in den Vertiefungen des Siliziumsubstrats gebildet. Optional kann die erste Siliziumdioxidschicht zusätzlich auf zumindest Teilen der Hauptoberfläche des Siliziumsubstrats oder auf der kompletten Hauptoberfläche des Siliziumsubstrats gebildet werden. Die erste Siliziumdioxidschicht wird beispielsweise ferner auf Teilen der Hauptoberfläche des Siliziumsubstrats gebildet, die die Vertiefungen miteinander verbinden. Es wird somit zumindest in den Vertiefungen des Siliziumsubstrats und optional zusätzlich auf der Hauptoberfläche des Siliziumsubstrats ein (ON)ₓ-Stapel mit x≥2 gebildet, wobei eine Siliziumdioxidschicht mit O bezeichnet ist und eine Siliziumnitridschicht mit N bezeichnet ist. Der Index x gibt dabei an wie viele ON-Schichtpaare übereinander angeordnet sind.

Gemäß einem Ausführungsbeispiel wird bei dem Oxidieren der polykristalinen Siliziumschicht eine Oxinitridschicht zwischen der ersten Siliziumnitridschicht und der zweiten Siliziumdioxidschicht gebildet. Dies führt zu einer sauberen Grenzfläche zwischen der Siliziumnitridschicht und der Siliziumdioxidschicht. Dadurch, dass die Oxinitridschicht gebildet wird, werden mögliche Defekte zwischen der Siliziumnitridschicht und der Siliziumdioxidschicht reduziert und eine elektrische Durchbruchfestigkeit erhöht.

Gemäß einem Ausführungsbeispiel wird bei dem Oxidieren der polykristalinen Siliziumschicht, die polykristaline Siliziumschicht vollständig in die zweite Siliziumdioxidschicht umgewandelt. Die Erfinder stellten fest, dass selbst wenn nur eine dünne polykristaline Siliziumschicht bestehen bleibt unvorhersehbare elektrische Prozesse in der Grabenkondensatorstruktur auftreten können und nur eine geringe Durchbruchfestigkeit erzielt werden kann. Dies basiert auf der Erkenntnis, dass es sich bei der polykristaline Siliziumschicht um eine Halbleiterschicht handelt. Da der Schichtstapel aus sich abwechselnden Siliziumdioxid- und Siliziumnitridschichten allerdings als Dielektrikum in der Grabenkondensatorstruktur dient, reduziert selbst eine dünne Halbleiterschicht zwischen den Schichten mit isolierendem Material eine Durchschlagfestigkeit des Schichtstapels.

Optional wird das Oxidieren, nachdem die polykristaline Siliziumschicht vollständig in die zweite Siliziumdioxidschicht umgewandelt wurde, weitergeführt, um die erste Siliziumnitridschicht teilweise zu oxidieren und eine Oxinitridschicht zwischen der ersten Siliziumnitridschicht und der zweiten Siliziumdioxidschicht zu bilden. Dadurch wird eine saubere Grenzfläche zwischen der Siliziumnitridschicht und der Siliziumdioxidschicht und eine hohe elektrische Durchbruchfestigkeit erzielt. Das Oxidieren wird beispielsweise für eine Zeitdauer von zumindest 5 min, 20 min oder 1h weitergeführt. Die Zeitdauer liegt beispielsweise in einem Bereich von 5 min-5 h, 20 min-5 h oder 1h-5 h, bevorzugt in einem Bereich von 5 min-1 h. Das Oxidieren wird in einem bevorzugten Ausführungsbeispiel für ca. 20 min oder für ca. 1 h fortgeführt.

Gemäß einem Ausführungsbeispiel ist die polykristaline Siliziumschicht undotiert. Dies basiert auf der Erkenntnis, dass dadurch in der Grabenkondensatorstruktur eine Siliziumdioxidschicht mit hoher Qualität gebildet werden kann. Die Erfinder stellten insbesondere fest, dass dadurch eine sehr reine Siliziumdioxidschicht mit geringem Leckstrom erzielt werden kann. Dies verbessert die elektrischen Eigenschaften der Grabenkondensatorstruktur.

Gemäß einem Ausführungsbeispiel wird die polykristaline Siliziumschicht mittels Niederdruck-Gasphasenabscheidung, d.h. mit einem LPCVD-Verfahren, auf der ersten Siliziumnitridschicht aufgebracht. Es wurde erkannt, dass zwar eine Abscheidung einer Siliziumoxidschicht direkt auf der Siliziumnitridschicht mittel LPCVD-Verfahren zu einer defektreichen Grenzfläche und einer geringen elektrischen Durchbruchfestigkeit führt, aber eine LPCVD-Abscheidung von polykristalinem Silizium und anschließender Oxidation des polykristalinen Siliziums zu einer sauberen Grenzfläche und einer hohen elektrische Durchbruchfestigkeit führt.

Gemäß einem Ausführungsbeispiel werden die erste Siliziumdioxidschicht, die erste Siliziumnitridschicht, die zweite Siliziumdioxidschicht und/oder die zweite Siliziumnitridschicht mit einer jeweiligen Schichtdicke in einem Bereich von 100 nm bis 1000 nm oder 330 nm bis 530 nm aufgebracht. Die einzelnen Schichten können dabei unterschiedliche Schichtdicken aufweisen. Es wurde ferner festgestellt, dass eine Abfolge von mehreren dünnen Siliziumdioxid- und Siliziumnitridschichten eine geringere Substratverbiegung und höhere Durchbruchfestigkeit erzielt, als eine Abfolge weniger dicker Siliziumdioxid- und Siliziumnitridschichten.

Gemäß einem Ausführungsbeispiel erfolgt das Bilden der ersten Siliziumdioxidschicht in den Vertiefungen des Siliziumsubstrats mittels thermischem Wachsen, das Aufbringen der ersten Siliziumnitridschicht auf der ersten Siliziumdioxidschicht mittels Niederdruck-Gasphasenabscheidung, d. h. einem LPCVD-Verfahren, und das Aufbringen der zweiten Siliziumnitridschicht auf der zweiten Siliziumdioxidschicht mittels Niederdruck-Gasphasenabscheidung, d. h. einem LPCVD-Verfahren.

Gemäß einem Ausführungsbeispiel bildet eine Siliziumnitridschicht zusammen mit einer Siliziumdioxidschicht ein Schichtpaar, wobei die Siliziumnitridschicht auf der Siliziumdioxidschicht angeordnet ist, z. B. von dem Siliziumsubstrat aus in Schichtstapelrichtung gesehen. In anderen Worten kann eine Siliziumdioxidschicht und eine Siliziumnitridschicht auf der Siliziumdioxidschicht als Schichtpaar bezeichnet werden. Ein Schichtpaar kann hierin auch als Schichtstapeleinheit bezeichnet werden. Die erste Siliziumdioxidschicht und die erste Siliziumnitridschicht bilden z. B. ein erstes Schichtpaar und die zweite Siliziumdioxidschicht und die zweite Siliziumnitridschicht bilden z. B. ein zweites Schichtpaar. Auf dem zweiten Schichtpaar kann zumindest ein weiteres Schichtpaar umfassend eine Siliziumdioxidschicht und eine Siliziumnitridschicht aufgebracht werden, d.h. von dem Siliziumsubstrat aus in Schichtstapelrichtung gesehen. Dabei wird z. B. die Siliziumdioxidschicht des jeweiligen weiteren Schichtpaares auf der Siliziumnitridschicht des jeweils vorrangehenden Schichtpaares aufgebracht. Das Aufbringen von Schichtpaaren umfassend eine Siliziumdioxidschicht und eine Siliziumnitridschicht wird mehrfach wiederholt. Es wird somit zumindest in den Vertiefungen des Siliziumsubstrats und optional zusätzlich auf der Hauptoberfläche des Siliziumsubstrats ein (ON)ₓ-Stapel mit x≥3 gebildet, wobei eine Siliziumdioxidschicht mit O bezeichnet ist und eine Siliziumnitridschicht mit N bezeichnet ist. Das zumindest eine weitere Schichtpaar wird z. B. auf dem zweiten Schichtpaar so aufgebracht, dass eine Schichtstruktur mit abwechselnden Siliziumdioxid- und Siliziumnitridschichten gebildet wird. Ab dem zweiten Schichtpaar wird die Siliziumdioxidschicht des jeweiligen Schichtpaares durch Aufbringen einer polykristalinen Siliziumschicht und Oxidieren der polykristalinen Siliziumschicht aufgebracht. Die Erfinder erkannten, dass auch bei einer dickeren dielektrischen Gesamtstapelschicht, d.h. bei mehr Siliziumdioxid- und Siliziumnitridschichten abwechselnd übereinander, die Integrationsdichte erhalten oder sogar erhöht werden kann. Es wurde festgestellt, dass durch das abwechselnde Übereinanderschichten von Siliziumdioxid- und Siliziumnitridschichten eine Substratverbiegung gering gehalten werden kann und gleichzeitig in den Vertiefungen des Siliziumsubstrats ein Schichtstapel mit einer großen Gesamtdicke, z. B. von zumindest 1600 nm, 2000 nm oder 3000 nm, realisiert werden kann. Dadurch wird ein Schichtstapel mit hoher Durchbruchfestigkeit, z. B. von zumindest 1200 V, 1400 V oder 1500 V, erzielt. Besonders vorteilhaft ist es, wenn ferner zwischen den einzelnen Schichtpaaren jeweils eine Oxinitridschicht gebildet wird.

Gemäß einem Ausführungsbeispiel erfolgt das Oxidieren der hierin beschriebenen polykristalinen Siliziumschichten mittels trockenchemischer Oxidation oder nasschemischer Oxidation. In anderen Worten werden die hierin beschriebenen Siliziumdioxidschicht thermisch gewachsen. Die trockenchemische oder nasschemische Oxidation kann hierin auch als trockenchemische oder nasschemische Reoxidation oder Aufoxidation bezeichnet werden. Die nasschemische Oxidation kann hierin auch als feuchtchemische Oxidation bezeichnet werden. Die Erfinder erkannten, dass die Bildung von Siliziumdioxidschichten mittels trockenchemischer oder nasschemischer Oxidation von polykristalinem Silizium zu saubereren Grenzflächen als auch zu einer höheren Durchbruchfestigkeit führt, als wenn die Siliziumdioxidschichten direkt mittels LPCVD-Verfahren (chemische-Niederdruck-Gasphasenabscheidung) oder PECVD-Verfahren (Plasmaunterstützte-chemische-Gasphasenabscheidung) aufgebracht werden. Dadurch werden Siliziumdioxidschichten mit hoher Qualität erzeugt und die elektrischen Eigenschaften der Grabenkondensatorstruktur verbessert. Die nasschemische Oxidation hat den Vorteil, dass die Siliziumdioxidschichten schneller gebildet werden können als mit der trockenchemischen Oxidation und die trockenchemische Oxidation hat gegenüber der nasschemischen Oxidation den Vorteil dass eine höhere Durchbruchfestigkeit des in den Vertiefungen des Siliziumsubstrat gebildeten Schichtstapels erzielt werden kann.

Gemäß einem Ausführungsbeispiel wird mit dem hierin beschriebenen Verfahren ein RC-Snubberelement gebildet bzw. hergestellt.

Ein weiteres Ausführungsbeispiel betrifft einen Grabenkondensator umfassend eine Dielektrikumschichtstruktur mit einer ersten Siliziumdioxidschicht, einer ersten Siliziumnitridschicht, einer zweiten Siliziumdioxidschicht und einer zweiten Siliziumnitridschicht. Der Grabenkondensator umfasst z. B. ein Siliziumsubstrat mit einer Grabenstruktur mit einer Mehrzahl von Vertiefungen in einer Hauptoberfläche des Siliziumsubstrats. Die Dielektrikumschichtstruktur ist z. B. in den Vertiefungen des Siliziumsubstrats angeordnet. Die erste Siliziumdioxidschicht, die erste Siliziumnitridschicht, die zweite Siliziumdioxidschicht und die zweite Siliziumnitridschicht sind in dieser Reihenfolgen angeordnet. Dabei können die Schichten direkt aneinandergrenzen. Optional ist zwischen der ersten Siliziumnitridschicht und der zweiten Siliziumdioxidschicht eine Oxinitridschicht angeordnet, wobei die Oxinitridschicht auch als Teil der ersten Siliziumnitridschicht angesehen werden kann. Bei der zweiten Siliziumdioxidschicht kann es sich um eine oxidierte polykristalinen Siliziumschicht handeln.

Der Grabenkondensator basiert auf den gleichen Überlegungen wie das oben beschriebene Verfahren. Der Grabenkondensator kann mit allen Merkmalen und Funktionen ergänzt werden, die auch im Hinblick auf das Verfahren beschrieben werden. Ferner können zumindest Teile des Grabenkondensators mit einem hierin beschriebenen Verfahren hergestellt werden.

### Figurenkurzbeschreibung

Ausführungsbeispiele gemäß der vorliegenden Erfindung werden nachfolgend Bezug nehmend auf die beiliegenden Figuren näher erläutert. Es zeigen:
- Fig. 1a: zeigt ein Blockdiagramm eines erfindungsgemäßen Ausführungsbeispiels eines Verfahrens zur Herstellung einer Grabenkondensatorstruktur;
- Fig. 1b: zeigt schematische Darstellungen von Verfahrensschritten eines erfindungsgemäßen Ausführungsbeispiels eines Verfahrens zur Herstellung einer Grabenkondensatorstruktur;
- Fig. 2: zeigt schematische Darstellungen von Verfahrensschritten eines erfindungsgemäßen Ausführungsbeispiels eines Verfahrens zur Herstellung einer Dielektrikumschichtstruktur mit Oxinitridschicht;
- Fig. 3: zeigt eine schematische Darstellung eines erfindungsgemäßen Ausführungsbeispiels einer Grabenkondensatorstruktur mit einer Mehrzahl von ON-Schichtpaaren;
- Fig. 4: zeigt eine schematische Darstellung eines erfindungsgemäßen Ausführungsbeispiels einer Grabenkondensatorstruktur mit einer Mehrzahl von ON-Schichtpaaren, die jeweils ferner eine Oxinitridschicht aufweisen;
- Fig. 5: zeigt ein Diagramm mit einer Kennlinie eines erfindungsgemäßen Ausführungsbeispiels eines Snubberbauelments, dessen Siliziumdioxidschichten mittels trockenchemischer Oxidation aufgebracht wurden, und einer Kennlinie eines Snubberbauelements dessen Siliziumdioxidschichten mittels LPCVD-Abscheidung aufgebracht wurden;
- Fig. 6: zeigt ein Diagramm mit einer Kennlinie eines erfindungsgemäßen Ausführungsbeispiels eines Snubberbauelments, dessen Siliziumdioxidschichten mittels trockenchemischer Oxidation aufgebracht wurden, und einer Kennlinie eines erfindungsgemäßen Ausführungsbeispiels eines Snubberbauelements dessen Siliziumdioxidschichten mittels nasschemischer Oxidation aufgebracht wurden; und
- Fig. 7: zeigt ein Diagramm mit einer Kennlinie eines erfindungsgemäßen Ausführungsbeispiels eines Snubberbauelments, dessen Siliziumdioxidschichten mittels trockenchemischer Oxidation aufgebracht wurden, und einer Kennlinie eines Snubberbauelements mit einer stressfreien Nitridschicht.

### Detaillierte Beschreibung der Ausführungsbeispiele gemäß den Figuren

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte und/oder Strukturen in den unterschiedlichen Figuren mit den gleichen oder ähnlichen Bezugszeichen versehen sind, so dass die in unterschiedlichen Ausführungsbeispielen dargestellte Beschreibung dieser Elemente untereinander austauschbar ist bzw. aufeinander angewendet werden kann.

Zur Erleichterung der Beschreibung der verschiedenen Ausführungsformen weisen einige der Figuren ein kartesisches Koordinatensystem x, y, z auf, wobei die x-y-Ebene einem ersten Hauptoberflächenbereich eines Substrats (= eine Bezugsebene = x-y-Ebene) entspricht, d.h. parallel zu diesem ist, wobei die Richtung senkrecht nach oben in Bezug auf die Bezugsebene (x-y-Ebene) der "+z"-Richtung entspricht, und wobei die Richtung senkrecht nach unten in Bezug auf die Bezugsebene (x-y-Ebene) der "-z"-Richtung entspricht. In der folgenden Beschreibung bedeutet der Begriff "lateral" eine Richtung parallel zur x- und/oder y-Richtung, d.h. parallel zur x-y-Ebene, wobei der Begriff "vertikal" eine Richtung parallel zur z-Richtung bedeutet.

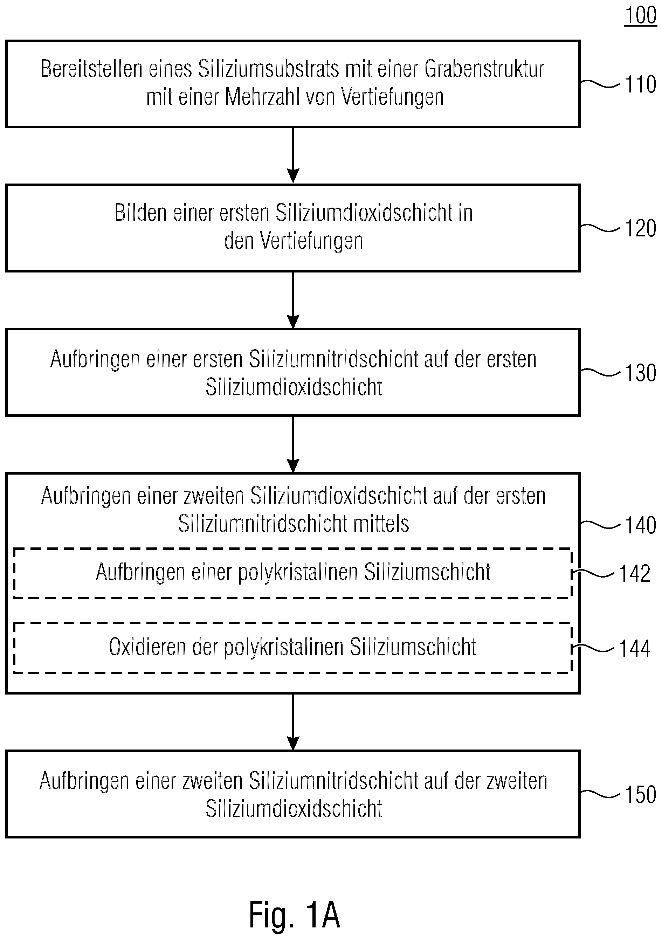

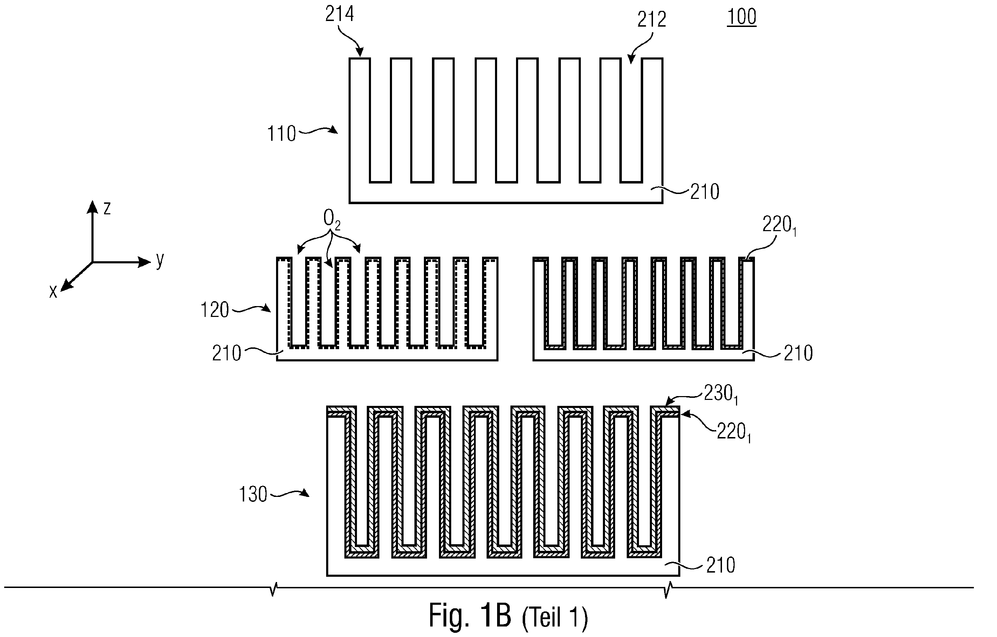

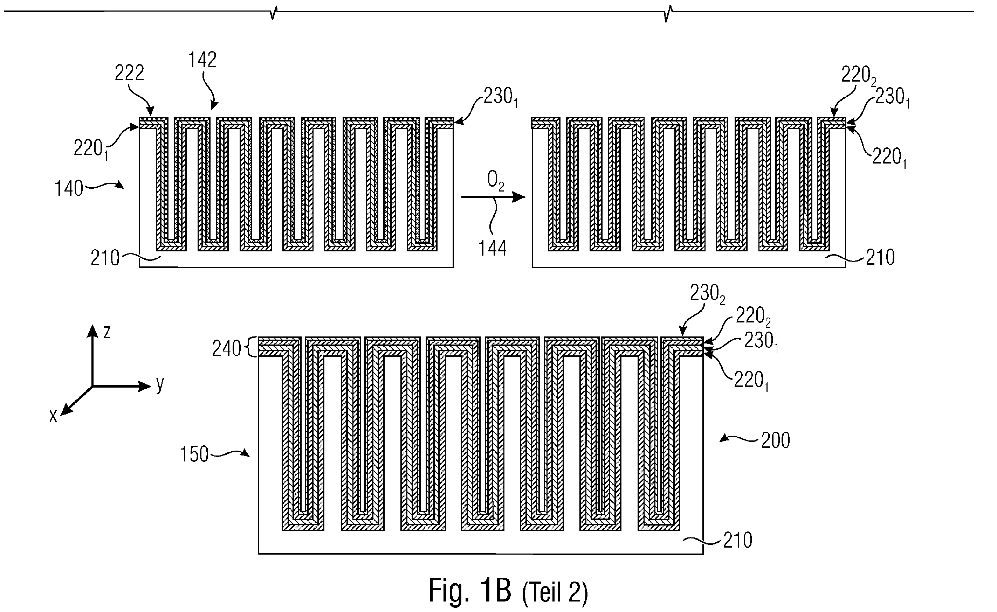

Fig. 1a und Fig. 1b zeigen ein Verfahren 100 zur Herstellung einer Grabenkondensatorstruktur 200 bzw. eines Grabenkondensators.

Das Verfahren 100 umfasst ein Bereitstellen 110 eines Siliziumsubstrats 210 mit einer Grabenstruktur. Die Grabenstruktur weist eine Mehrzahl von Vertiefungen 212 in einer Hauptoberfläche 214 des Siliziumsubstrats 210 auf. Bei dem Siliziumsubstrat 210 kann es sich z. B. um einen Siliziumwafer handeln. Für das Verfahren 100 kann beispielsweise ein vorgefertigtes Siliziumsubstrat 210 mit bereits integrierter Grabenstruktur verwendet werden. Alternativ kann das Bereitstellen 110 des Siliziumsubstrats 210 mit der Grabenstruktur ein Bilden der Grabenstruktur in der Hauptoberfläche 214 des Siliziumsubstrats 210 aufweisen. Das Bilden der Grabenstruktur erfolgt beispielsweise mittels Siliziumsubstratstrukturierung. Das Bilden der Grabenstruktur in der Hauptoberfläche 214 des Siliziumsubstrats 210 kann einen oder mehrere lithographische Schritte und einen oder mehrere Ätzschritte aufweisen.

Ein weiterer Schritt des Verfahrens 100 betrifft ein Bilden 120 einer ersten Siliziumdioxidschicht 220₁ zumindest in den Vertiefungen 212 des Siliziumsubstrats 210. In Fig. 1b wird die erste Siliziumdioxidschicht 220₁ beispielhaft auch auf der Hauptoberfläche 214 des Siliziumsubstrats 210 gebildet. Die erste Siliziumdioxidschicht 220₁ wird beispielsweise mittels thermischem Wachsen bzw. thermischer Oxidation gebildet. Hierfür wird z. B. das Siliziumsubstrat 210 trockenchemisch oder nasschemisch oxidiert, wobei die trockenchemische Oxidation bevorzugt wird. Es werden beispielsweise Oberflächen innerhalb der Mehrzahl von Vertiefungen 212 und optional die Hauptoberfläche 214 oder Teile der Hauptoberfläche 214 oxidiert, um die erste Siliziumdioxidschicht 220₁ zu bilden. Die erste Siliziumdioxidschicht 220₁ weist z. B. SiO₂-Material bzw. thermisches Oxid auf. Eine Dicke der ersten Siliziumdioxidschicht 220₁ liegt z. B. in einem Bereich von 100 nm bis 1000 nm, bevorzugt in einem Bereich von 100 nm bis 450 nm, wie z. B. bei 330 nm.

Auf die erste Siliziumdioxidschicht 220₁ wird eine erste Siliziumnitridschicht 230₁ aufgebracht 130. Die erste Siliziumnitridschicht 230₁ wird beispielsweise mittels Niederdruck-Gasphasenabscheidung, d. h. mit einem LPCVD-Verfahren, abgeschieden. Die erste Siliziumnitridschicht 230₁ weist z. B. Si₃N₄-Material auf. Eine Dicke der ersten Siliziumnitridschicht 230₁ liegt z. B. in einem Bereich von 100 nm bis 1000 nm, bevorzugt in einem Bereich von 100 nm bis 550 nm, wie z. B. bei 460 nm.

Auf die erste Siliziumnitridschicht 230₁ wird eine zweite Siliziumdioxidschicht 220₂ aufgebracht 140. Hierbei wird eine polykristaline Siliziumschicht 222, d. h. Polysilizium, auf der ersten Siliziumnitridschicht 230₁ aufgebracht 142 und oxidiert 144. Die polykristaline Siliziumschicht 222 ist beispielsweise undotiert. Die polykristaline Siliziumschicht 222 wird z. B. mittels Niederdruck-Gasphasenabscheidung, d. h. mit einem LPCVD-Verfahren, abgeschieden. Die Oxidation 144 der polykristalinen Siliziumschicht 222 erfolgt beispielsweise trockenchemisch oder nasschemisch, wobei die trockenchemische Oxidation bevorzugt wird. Eine Dicke der zweiten Siliziumdioxidschicht 220₂ liegt z. B. in einem Bereich von 100 nm bis 1000 nm, bevorzugt in einem Bereich von 100 nm bis 450 nm, wie z. B. bei 330 nm.

Das Verfahren 100 weist ferner ein Aufbringen 150 einer zweiten Siliziumnitridschicht 230₂ auf der zweiten Siliziumdioxidschicht 220₂ auf. Die zweite Siliziumnitridschicht 230₂ wird beispielsweise mittels Niederdruck-Gasphasenabscheidung, d. h. mit einem LPCVD-Verfahren, abgeschieden. Die zweite Siliziumnitridschicht 230₂ weist z. B. Si₃N₄-Material auf. Eine Dicke der zweiten Siliziumnitridschicht 230₂ liegt z. B. in einem Bereich von 100 nm bis 1000 nm, bevorzugt in einem Bereich von 100 nm bis 550 nm, wie z. B. bei 530 nm.

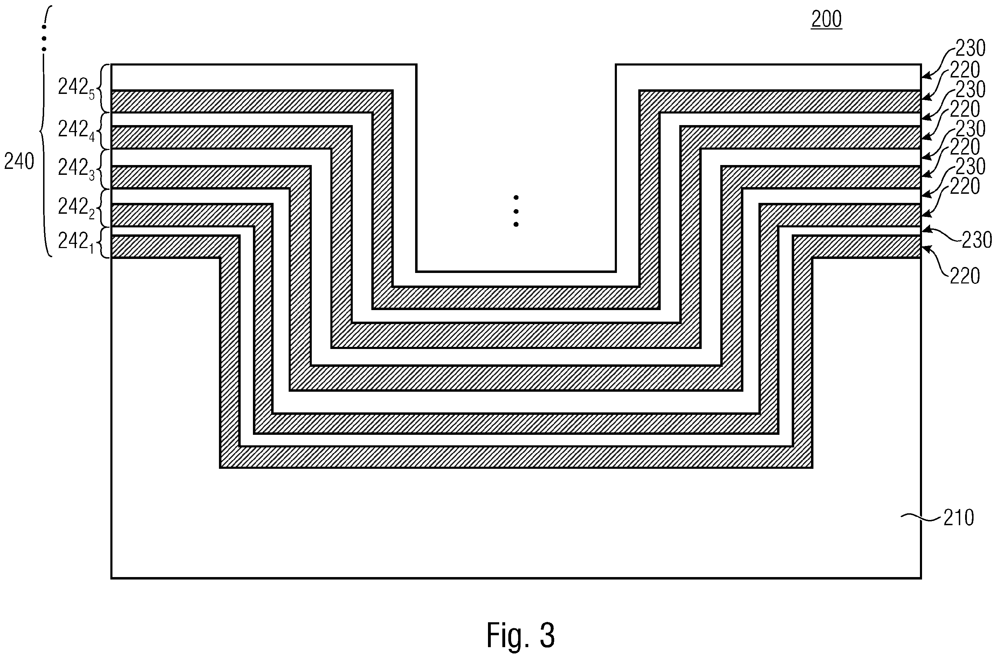

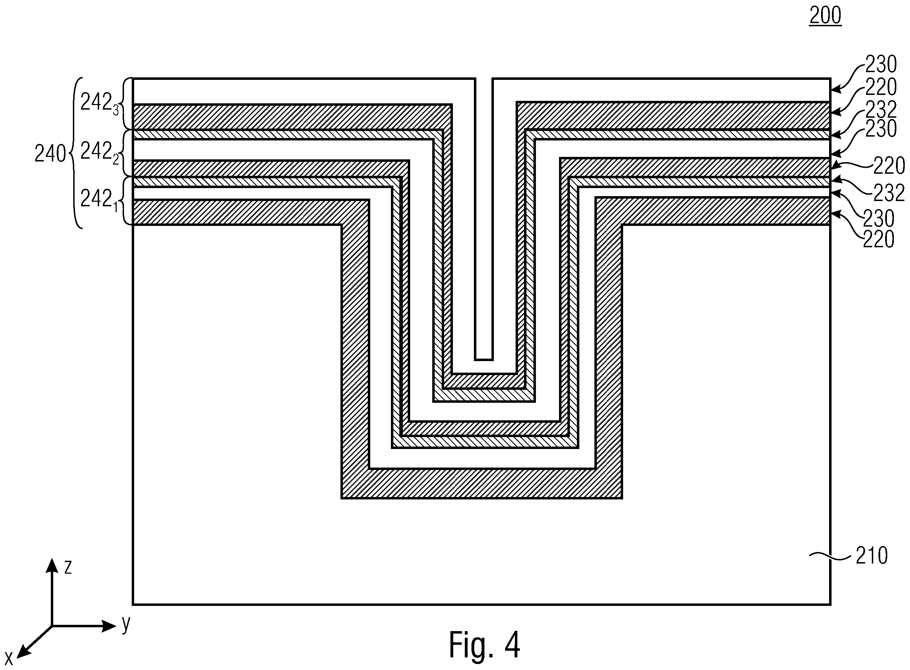

Somit wird ein Grabenkondensator, siehe die Grabenkondensatorstruktur 200, mit einer Dielektrikumschichtstruktur 240 gebildet bzw. bereitgestellt. Die Dielektrikumschichtstruktur 240 weist die erste Siliziumdioxidschicht 220₁, die erste Siliziumnitridschicht 230₁, die zweite Siliziumdioxidschicht 220₂ und die zweite Siliziumnitridschicht 230₂ auf. Optional kann die Dielektrikumschichtstruktur 240 weitere Siliziumdioxid- und Siliziumnitridschichten aufweisen, siehe z. B. Fig. 3 und Fig. 4. Die Dielektrikumschichtstruktur 240 ist zumindest in der Mehrzahl von Vertiefungen 212, z. B. auf Oberflächen der Mehrzahl von Vertiefungen 212, angeordnet. Optional ist die Dielektrikumschichtstruktur 240 ferner auf der Hauptoberfläche 214 des Siliziumsubstrats 210 oder auf Teilen der Hauptoberfläche 214 des Siliziumsubstrats 210 angeordnet.

Die erste Siliziumdioxidschicht 220₁, die erste Siliziumnitridschicht 230₁, die zweite Siliziumdioxidschicht 220₂ und die zweite Siliziumnitridschicht 230₂ sind z. B. in dieser Reihenfolge aneinandergrenzen angeordnet. Die Dielektrikumschichtstruktur 240 kann auch als Schichtstapel mit dielektrischen Schichten, siehe die Schichten 220₁, 220₂, 230₁ und 230₂, angesehen werden. Die erste Siliziumdioxidschicht 220₁ ist beispielsweise direkt auf dem Substrat 210 des Grabenkondensators angeordnet und die erste Siliziumnitridschicht 230₁, die zweite Siliziumdioxidschicht 220₂ und die zweite Siliziumnitridschicht 230₂ sind z. B. in dieser Reihenfolgen auf der ersten Siliziumdioxidschicht 220₁ angeordnet. Die Reihenfolge der dielektrischen Schichten der Dielektrikumschichtstruktur 240 ist beispielsweise von dem Siliziumsubstrat 210 aus in Schichtstapelrichtung angegeben.

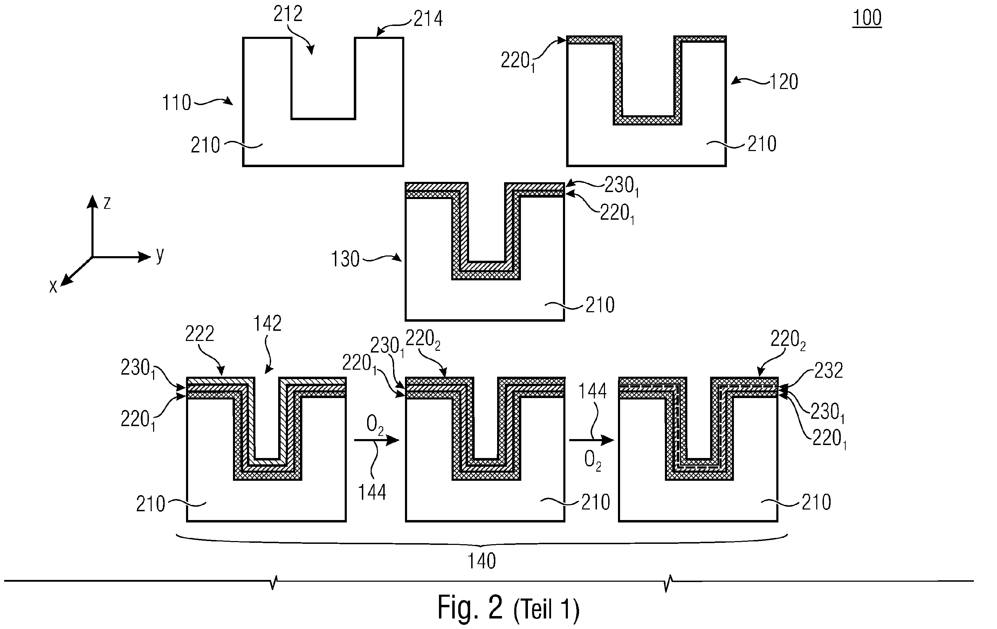

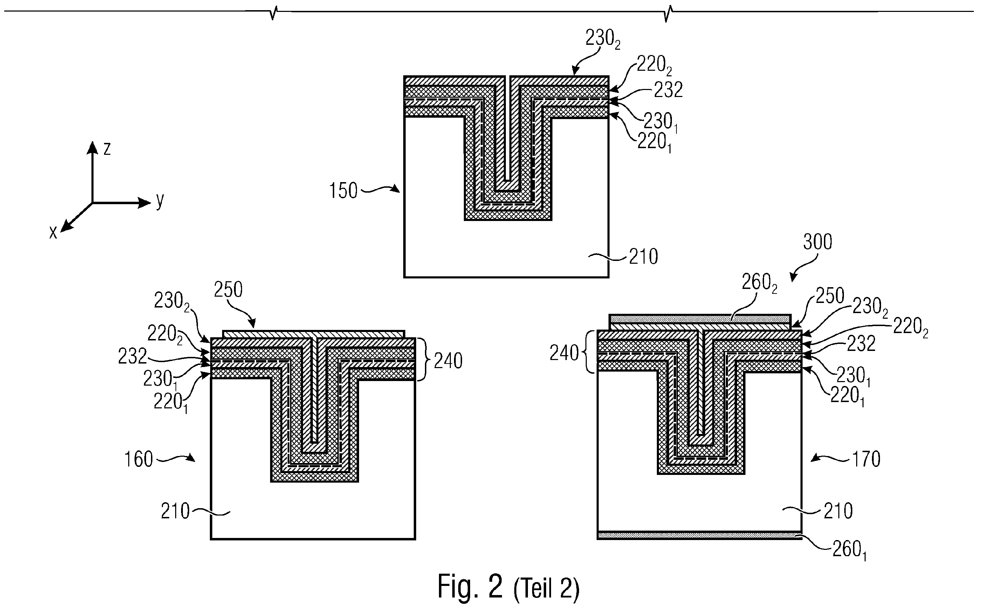

Optional kann das Verfahren 100 weitere Schritte, wie sie in Zusammenhang mit Fig. 2 beschrieben sind, aufweisen. Genauso kann die Grabenkondensatorstruktur 200 z. B. weitere Schichten, wie sie in Zusammenhang mit Fig. 2 beschrieben sind, aufweisen. Die erste Siliziumnitridschicht 230₁ kann z. B. die in Zusammenhang mit Fig. 2 beschriebene Oxinitridschicht 232 aufweisen. Die Oxinitridschicht 232 der ersten Siliziumnitridschicht 230₁ ist z. B. an einer Grenzfläche zwischen der ersten Siliziumnitridschicht 230₁ und der zweiten Siliziumdioxidschicht 220₂ angeordnet.

Fig. 2 zeigt exemplarisch das Verfahren 100 für einen Ausschnitt einer durch das Verfahren gebildeten Grabenkondensatorstruktur 200. In anderen Worten, wird schematisch eine Vertiefung 212 der Mehrzahl von Vertiefungen der Grabenstruktur in dem Siliziumsubstrat 210 und die darin aufgebrachten Schichten im Detail gezeigt. Das heißt, Fig. 2 zeigt die Verfahrensschritte im Detail für eine der Mehrzahl von Vertiefungen der Grabenstruktur. Auch wenn Fig. 2 die Verfahrensschritte nur in Zusammenhang mit einer Vertiefung 212 der Mehrzahl von Vertiefungen zeigt, ist klar, dass die Verfahrensschritte auch in Zusammenhang mit den restlichen Vertiefungen der Mehrzahl von Vertiefungen angewendet werden können.

Das Verfahren 100 in Fig. 2 weist, wie auch das Verfahren 100 in Fig. 1a und 1b, die Schritte Bereitstellen 110 des Siliziumsubstrats 210; Bilden 120 der ersten Siliziumdioxidschicht 220₁ in den Vertiefungen 212 des Siliziumsubstrats 210; Aufbringen 130 der ersten Siliziumnitridschicht 230₁ auf der ersten Siliziumdioxidschicht 220₁; Aufbringen 140 der zweiten Siliziumdioxidschicht 220₂ auf der ersten Siliziumnitridschicht 230₁; und Aufbringen 150 der zweiten Siliziumnitridschicht 230₂ auf der zweiten Siliziumdioxidschicht 220₂, auf.

Wie in Zusammenhang mit Fig. 1a und Fig. 1b beschrieben, weist das Aufbringen 140 der zweiten Siliziumdioxidschicht 220₂ auf der ersten Siliziumnitridschicht 230₁ ein Aufbringen 142 der polykristalinen Siliziumschicht 222 und ein Oxidieren 144 der polykristalinen Siliziumschicht 222 auf. Dabei kann das Oxidieren 144 z. B. trockenchemisch oder nasschemisch erfolgen. Bei dem Oxidieren 144 der polykristalinen Siliziumschicht 222 wird optional eine Oxinitridschicht 232 zwischen der ersten Siliziumnitridschicht 230₁ und der zweiten Siliziumdioxidschicht 220₂, bzw. in der ersten Siliziumnitridschicht 230₁ an einer Grenzfläche zwischen der ersten Siliziumnitridschicht 230₁ und der zweiten Siliziumdioxidschicht 220₂, gebildet. Die polykristaline Siliziumschicht 222 wird z. B. vollständig in die zweite Siliziumdioxidschicht 220₂ umgewandelt, d. h. komplett aufoxidiert, und optional wird im Anschluss daran das Oxidieren 144 weitergeführt, um die erste Siliziumnitridschicht 230₁ teilweise zu oxidieren und die Oxinitridschicht 232 in der ersten Siliziumnitridschicht 230₁, bzw. an einer Grenzfläche zwischen der ersten Siliziumnitridschicht 230₁ und der zweiten Siliziumdioxidschicht 220₂ zu bilden. Die Nitrid-Oberfläche der ersten Siliziumnitridschicht 230₁ wird z. B. wenige nm tief oxidiert, indem das Oxidieren 144 länger fortgeführt wird, als für den kompletten Verbrauch des polykristallinen Siliziums notwendig. dieser Schritt ist optional und soll v.a. die Grenzfläche zwischen Oxid und Nitrid optimieren/defektfreier machen. Die erste Siliziumnitridschicht 230, dient z. B. als Oxidationsstop. Eine Oxidationsdauer des Oxidierens 144 liegt z. B. in einem Bereich von 5 h-72 h, 5 h-48 h oder 5 h-32 h, wie z. B. bei 9.75h oder 10 h. Das Oxidieren 144 wird z. B., abhängig von einer Dicke der zu bildenden zweiten Siliziumdioxidschicht 220₂, für eine Zeitdauer von zumindest 5 h, 9h oder 24 h durchgeführt, um sicherzustellen, dass die polykristaline Siliziumschicht 222 vollständig in die zweite Siliziumdioxidschicht 220₂ umgewandelt wurde und die Oxinitridschicht 232 gebildet wurde. Je dicker die zu bildende zweiten Siliziumdioxidschicht 220₂ bzw. die zu oxidierende polykristaline Siliziumschicht 222, desto länger sollte die Oxidation 144 durchgeführt werden.

Die Oxinitridschicht 232 weist z. B. thermisches Oxid auf. Eine Dicke der Oxinitridschicht 232 liegt z. B. in einem Bereich von 1 nm bis 12 nm oder 1 nm bis 11 nm. Die Oxinitridschicht 232 weist vorzugsweise eine maximale Dicke von 11 nm auf.

Die erste Siliziumdioxidschicht 220₁, die erste Siliziumnitridschicht 230₁, die Oxinitridschicht 232, die zweite Siliziumdioxidschicht 220₂ und die zweite Siliziumnitridschicht 230₂ bilden z. B. eine Dielektrikumschichtstruktur 240.

Optional kann auf die zweite Siliziumnitridschicht 230₂ eine Schicht 250 mit dotiertem Polysiliziummaterial aufgetragen 160 werden. Die Schicht 250 mit dotiertem Polysiliziummaterial wird beispielsweise so aufgetragen 160, dass zumindest die Vertiefungen 212, in denen die Siliziumdioxid- und Siliziumnitridschichten angeordnet sind, mit dem dotierten Polysiliziummaterial aufgefüllt sind. Die Schicht 250 mit dotiertem Polysiliziummaterial schließt beispielsweise die Mehrzahl von Vertiefungen 212 ab. Die Schicht 250 mit dotiertem Polysiliziummaterial kann ferner auf einer von der Hauptoberfläche des Siliziumsubstrats 210 abgewandten Oberfläche der zweiten Siliziumnitridschicht 230₂ aufgebracht 160 werden. Die Schicht 250 mit dotiertem Polysiliziummaterial wird beispielsweise so aufgetragen 160, dass auf einer der Dielektrikumschichtstruktur 240 abgewandten Seite der Schicht 250 eine Oberfläche parallel zu der Hauptoberfläche 214 des Siliziumsubstrats 210 gebildet wird. Die Schicht 250 mit dotiertem Polysiliziummaterial wird z. B. mittels Niederdruck-Gasphasenabscheidung, d. h. mit einem LPCVD-Verfahren, abgeschieden. Bei dem dotierten Polysiliziummaterial handelt es sich z. B. um insitu dotiertes polykristalines Siliziummaterial. Die Schicht 250 mit dotiertem Polysiliziummaterial bildet z. B. eine Elektrode, wie z. B. eine vorderseitige Elektrode, eines RC-Snubberelements 300.

Optional kann ferner auf der Schicht 250 mit dotiertem Polysiliziummaterial und auf einer der Dielektrikumschichtstruktur 240 abgewandten Seite des Siliziumsubstrats 210 jeweils eine Aluminiumschicht, siehe 260₁ und 260₂, abgeschieden 170 werden. Bei den Aluminiumschichten 260₁ und 260₂ handelt es sich z. B. um Vorderseiten- und Rückseitenmetallisierungen eines RC-Snubberelements 300.

Ein Grabenkondensator bzw. ein RC-Snubberelement 300 weist z. B. ein Siliziumsubstrat 210 mit einer Grabenstruktur mit einer Mehrzahl von Vertiefungen 212 und die Dielektrikumschichtstruktur 240 zumindest in den Vertiefungen 212 des Siliziumsubstrats 210 auf. Die erste Siliziumdioxidschicht 220₁ der Dielektrikumschichtstruktur 240 ist beispielsweise direkt auf dem Substrat 210 des Grabenkondensators angeordnet und die erste Siliziumnitridschicht 230₁ mit der Oxinitridschicht 232, die zweite Siliziumdioxidschicht 220₂ und die zweite Siliziumnitridschicht 230₂ sind z. B. in dieser Reihenfolgen auf der ersten Siliziumdioxidschicht 220₁ angeordnet. Die Reihenfolge der dielektrischen Schichten der Dielektrikumschichtstruktur 240 ist beispielsweise von dem Siliziumsubstrat 210 aus in Schichtstapelrichtung angegeben. Optional weist der Grabenkondensator eine dotierte polykristalinen Siliziumschicht, siehe die Schicht 250, auf einer dem Siliziumsubstrat 210 abgewandten Oberfläche der Dielektrikumschichtstruktur 240 auf. Ferner kann der Grabenkondensator z. B. auf einer der Hauptoberfläche 214 gegenüberliegenden Oberfläche des Siliziumsubstrats 210 eine erste Aluminiumschicht 260, aufweisen und auf einer der Hauptoberfläche 214 abgewandten Oberfläche der dotierten polykristalinen Siliziumschicht eine zweite Aluminiumschicht 260₂ aufweisen.

Fig. 1a-2 zeigen (ON)ₓ-Snubber Prozessierungen mit x=2. Es sind aber auch Verfahren 100 oder eine Grabenkondensatorstruktur 200, z. B. für einen Grabenkondensatoren bzw. für ein RC-Snubberelement 300, mit mehr ON-Schichtpaaren, d. h. Siliziumdioxid-Siliziumnitrid-Schichtpaaren, möglich. Fig. 3 zeigt beispielhaft eine Grabenkondensatorstruktur 200 mit x≥5 und Fig. 4 zeigt beispielhaft eine Grabenkondensatorstruktur 200 mit x=3. Die hierin diskutierten Siliziumdioxidschichten können auch als Oxidschichten bzw. mit dem Buchstaben O bezeichnet werden. Die hierin diskutierten Siliziumnitridschichten können auch als Nitridschichten bzw. mit dem Buchstaben N bezeichnet werden.

Wie in Fig. 3 und Fig. 4 dargestellt kann eine hierin beschriebene Dielektrikumschichtstruktur 240 drei oder mehr Siliziumdioxid-Siliziumnitrid-Schichtpaare, d.h. ON-Schichtpaare 242, aufweisen, siehe z. B. 242₁₋₅ in Fig. 3 und 242₁₋₃ in Fig. 4. Eine Siliziumdioxidschicht 220 und eine Siliziumnitridschicht 230 bilden zusammen ein ON-Schichtpaar 242. Von dem Siliziumsubstrat 210 aus gesehen in Schichtstapelrichtung, d. h. in Richtung der Dielektrikumschichtstruktur 240, ist z. B. innerhalb eines ON-Schichtpaars 242 die jeweilige Siliziumnitridschicht 230 auf der jeweiligen Siliziumdioxidschicht 220 angeordnet.

Die ON-Schichtpaare 242 sind in Schichtstapelrichtung übereinander angeordnet. Ab dem zweiten Schichtpaar 242₂ ist die jeweilige Siliziumdioxidschicht 220 auf einer Siliziumnitridschicht 230 des jeweils vorrangehenden Schichtpaares 242 angeordnet. Die Dielektrikumschichtstruktur 240 weist z. B. einen Schichtstapel mit sich abwechselnden Siliziumdioxid- und Siliziumnitridschichten auf.

Ab dem zweiten Schichtpaar 242₂ wird die jeweilige Siliziumdioxidschicht 220 durch Aufbringen einer polykristalinen Siliziumschicht und Oxidieren der polykristalinen Siliziumschicht aufgebracht. Optional kann das Oxidieren nachdem die jeweilige polykristaline Siliziumschicht komplett in die jeweilige Siliziumdioxidschicht 220 umgewandelt wurde, weitergeführt werden, um die Nitrid-Oberfläche der jeweiligen Siliziumnitridschicht 230₁, auf der die jeweilige Siliziumdioxidschicht 220 angeordnet ist, zu Oxidieren und jeweils eine Oxinitridschicht 232 zu bilden.

Bei einer Dielektrikumschichtstruktur 240 mit x ON-Schichtpaaren 242 können, wie in Fig. 4 exemplarisch gezeigt, die erste Siliziumnitridschicht 230 bis zur (x-1)ten Siliziumnitridschicht 230 jeweils eine Oxinitridschicht 232 aufweisen, wobei x≥3. Die Oxinitridschichten sind z. B. jeweils an einer Grenzfläche zu einem darauffolgenden Schichtpaar 242 angeordnet. Das heißt, bei einer Bildung eines neuen Schichtpaares 242 auf einem vorrangehendem Schichtpaar 242, wird eine Nitrid-Oberfläche der Siliziumnitridschicht 230 des vorrangehenden Schichtpaares z. B. wenige nm tief oxidiert, um die Oxinitridschicht 232 zu bilden, wobei die Nitrid-Oberfläche dem neuen Schichtpaar 242 zugewandt angeordnet ist.

Gemäß einem Ausführungsbeispiel können die Oxinitridschichten 232 alternativ als eigenständige Schichten angesehen werden, die jeweils zwischen zwei aufeinanderfolgenden ON-Schichtpaaren 242 angeordnet sind.

Optional können die in Fig. 3 und Fig. 4 dargestellten Grabenkondensatorstrukturen 200 ferner die in Zusammenhang mit Fig. 2 beschriebene dotierte polykristalinen Siliziumschicht 250 und/oder die Aluminiumschichten 160, und 260₂ aufweisen.

Anstatt, wie in dem zu Beginn dieser Anmeldung erwähnten Patent DE 102019204503 B3, auf stressfreies Nitrid zu setzten, wird auf die zugrundeliegenden dielektrischen Schichten Siliziumdioxid (thermisch gewachsen) und Siliziumnitrid (via LPCVD abgeschieden), siehe Patent DE102014223904A1, erneut diese dielektrischen Schichten (Siliziumdioxid unter Siliziumnitrid) in beliebiger Anzahl, größer als zwei, an Wiederholungen mit Schichtdicken von je 100 nm bis 1000 nm erzeugt und somit weiterhin die entgegengesetzten Materialspannungen zur Reduzierung bzw. Kontrolle der Waferverbiegung genutzt und dabei die Durchbruchspannung deutlich erhöht. Durch die gegeneinander wirkenden mechanischen Spannungen kann die Lochtiefe und damit die Oberflächenvergrößerung des Kondensators erhöht werden und auch bei einer dickeren dielektrischen Gesamtstapelschicht die Integrationsdichte erhalten oder sogar erhöht werden.

Um die Qualität der Siliziumdioxidschichten 220 zu maximieren, werden diese mittels thermischer Oxidation erzeugt. Die erste Siliziumdioxidschicht 220₁ wird somit auf dem Siliziumsubstrat 210 thermisch gewachsen, für die weiteren Siliziumdioxidschichten 220₂-220ₓ (mit x≥3) werden auf den jeweiligen Siliziumnitridschichten 230₁-230ₓ₋₁ (mit x≥3) jeweils eine Schicht undotiertes polykristallines Silizium (100-1000 nm) mittels LPCVD abgeschieden und thermisch komplett trockenchemisch oxidiert bzw. reoxidiert. Nachdem die jeweilige polykristalline Siliziumschicht 222 komplett in Siliziumdioxid 220 umgewandelt wurde, wird noch eine gewisse Zeit weiter oxidiert, so dass auch das Siliziumnitrid 230 etwas oxidiert wird und sich eine Oxinitridschicht 232 bildet. Dies führt zu einer sauberen Grenzfläche zwischen der Siliziumnitridschicht 230 und der Siliziumdioxidschicht 220, das Siliziumnitrid dient hier quasi als "Wachstumsstopp" und wird nur geringfügig oxidiert aufgrund der sehr geringen Trockenoxidationsrate von Siliziumnitrid an sich (siehe R. L. Guldi et al 1989 J. Electrochem. Soc. 136 3815, DOI 10.1149/1.2096555) und der zum Teil dicken Siliziumdioxidschicht 220 (ehemals polykristallines Silizium 222) darüber, was die Diffusion des Sauerstoffs an das Siliziumnitrid verlangsamt. Durch einen stetigen Ausgleich der mechanischen Spannungen durch die entgegengesetzten Drücke von Siliziumnitrid und Siliziumoxid wird die Waferverbiegung so gering wie möglich gehalten, womit die Integrationsdichte durch Vergrößerung der Lochtiefe und gleichzeitig die Dicke des gesamten dielektrischen Stapels, und damit die Durchbruchfestigkeit, weiter erhöht werden kann.

Eine Erhörung der Durchbruchfestigkeit konnte mit den bisher bekannten Materialien und Verfahren nur über eine Erhöhung der Gesamtschichtdicke erreicht werden. Dies führt einerseits zu einer Vergrößerung der Waferverbiegung und andererseits zu einer Reduzierung der Integrationsdichte. Möchte man die Integrationsdichte erhöhen, müssen tiefere Löcher erzeugt werden, was wiederum die Waferverbiegung erhöht. Als Lösung werden die Gegenseitigen mechanischen Drücke der hierin genutzten Dielektrika, d. h. der Siliziumdioxidschicht 220 und Siliziumnitridschicht 230, genutzt, und zwar indem mindestens zwei Siliziumdioxidschicht 220 und mindestens zwei Siliziumnitridschicht 230 abwechselnd übereinander angeordnet werden. Um dies mit den bestmöglichen elektrischen Eigenschaften zu verknüpfen, wird statt LPCVD- oder PECVD-Verfahren, das trockenchemische Oxidieren bzw. Aufoxidieren oder Reoxidieren des Polysiliziums genutzt, um die Siliziumdioxidschicht 220 zu bilden und den Schichtstapel zu erzeugen.

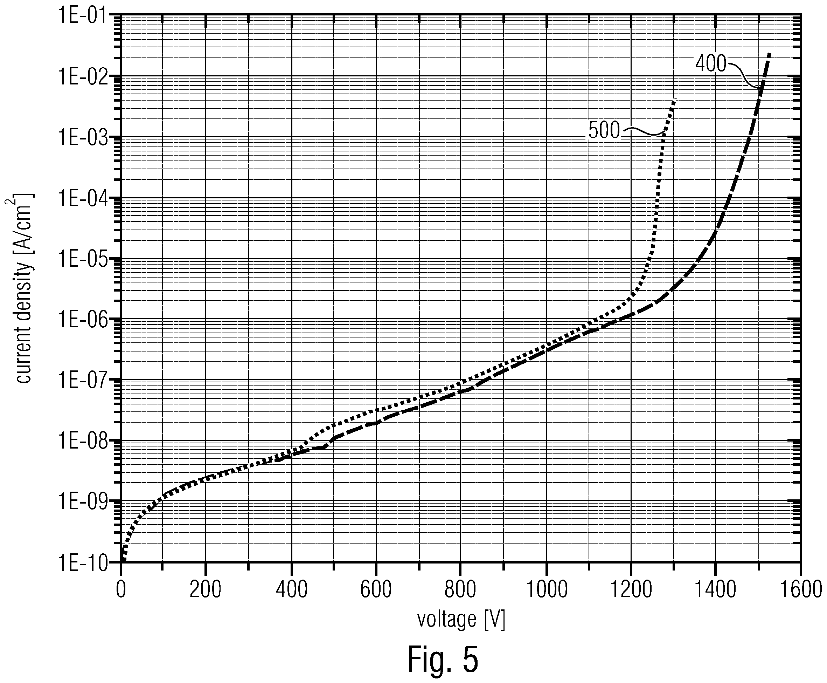

Mittels Abscheidung der Siliziumdioxidschichten direkt auf den Siliziumnitridschichten, z.B. über LPCVD- oder PECVD-Verfahren, kann ein grundsätzlich ähnlicher Stapel erzeugt werden. Allerdings sind die Grenzflächen bei der Nutzung von LPCVD- oder PECVD-Verfahren defektreicher und die elektrisch Durchbruchfestigkeit ist deutlich geringer, siehe Fig. 5. Fig. 5 zeigt eine erste Kennlinie 400 für ein Bauelement, das gemäß Fig. 2 hergestellt wurde und eine äquivalenten Oxiddicke von ca. 1175 nm aufweist. Die Siliziumdioxidschichten des Bauelements, das der Kennlinie 400 zugrunde liegt, wurden mittels trockenchemischer Oxidation aufgebracht. Ferner zeigt Fig. 5 eine zweite Kennlinie 500 für ein gleich aufgebautes Bauelement, bei dem allerdings die Siliziumdioxidschichten mittels LPCVD-Abscheidung aufgebracht wurden und nicht mittels trockenchemischer Oxidation einer Polysiliziumschicht.

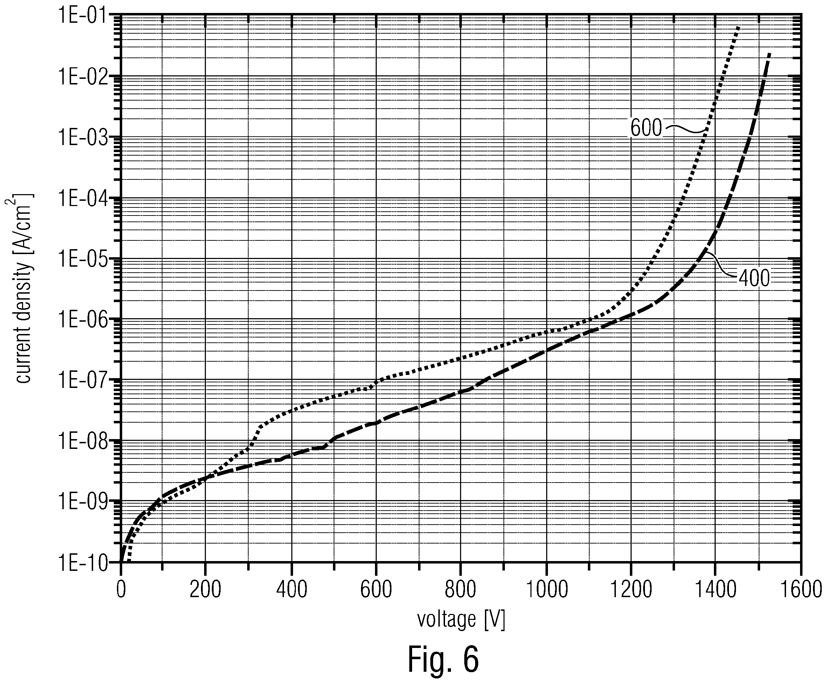

Auch kann das polykristalline Silizium nass- statt trockenchemisch reoxidiert werden, was prozesstechnisch auch schneller funktioniert, jedoch ebenso eine geringere Druchbruchfestigkeit aufweist, siehe Fig. 6. Fig. 6 zeigt eine erste Kennlinie 400 für ein Bauelement, das gemäß Fig. 2 hergestellt wurde und eine äquivalenten Oxiddicke von ca. 1175 nm aufweist. Die Siliziumdioxidschichten des Bauelements, das der Kennlinie 400 zugrunde liegt, wurden mittels trockenchemischer Oxidation aufgebracht. Ferner zeigt Fig. 6 eine zweite Kennlinie 600 für ein ebenfalls gemäß Fig. 2 hergestelltes Bauelement, bei dem allerdings Siliziumdioxidschichten (z. B. zumindest die Siliziumdioxidschichten ab der zweiten Siliziumdioxidschicht 220₂) mittels feuchtchemischer bzw. nasschemischer Oxidation einer Polysiliziumschicht aufgebracht wurden und nicht mittels trockenchemischer Oxidation einer Polysiliziumschicht.

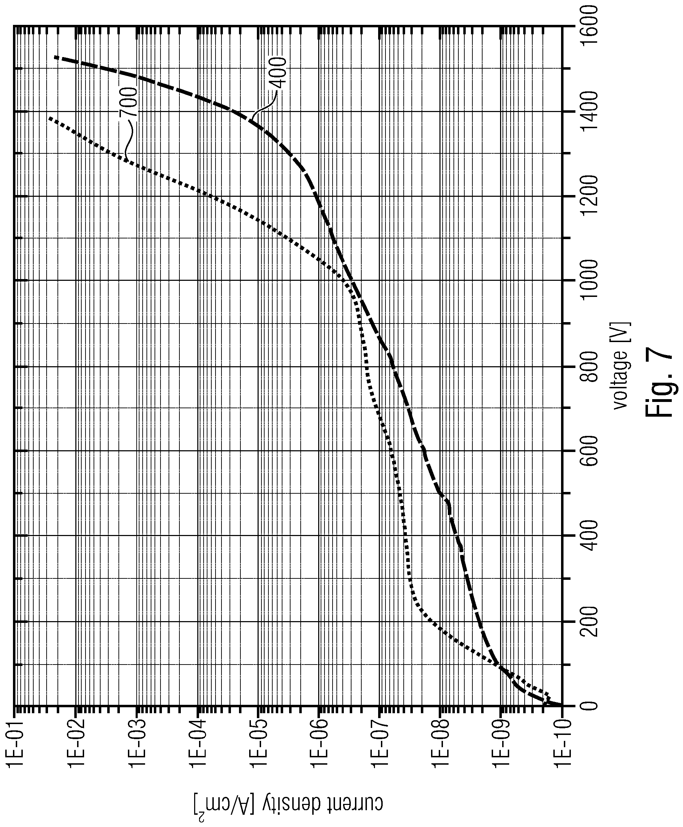

Des Weiteren weist das Bauelement gemäß Fig. 2 auch eine höhere Durchbruchfestigkeit gegenüber Bauelementen mit stressfreier Nitridschicht, wie aus DE102019204503B3 bekannt, auf. Fig. 7 zeigt eine erste Kennlinie 400 für ein Bauelement, das gemäß Fig. 2 hergestellt wurde und eine äquivalenten Oxiddicke von ca. 1175 nm aufweist. Die Siliziumdioxidschichten des Bauelements, das der Kennlinie 400 zugrunde liegt, wurden mittels trockenchemischer Oxidation aufgebracht. Ferner zeigt Fig. 7 eine zweite Kennlinie 700 für ein Bauelement mit einer Dielektrikumschichtstruktur mit 330 nm SiOz, 550 nm Si₃N₄, 500 nm SiₓN_{y} und 500 nm Si₃N₄ mit einer äquivalenten Oxiddicke von ca. 1085 nm.

Mit den hierin beschriebenen Verfahren 100 können Bauelemente, z. B. RC-Snubberelemente, mit Spannungsklassen von mindestens 1000 V, 1200 V oder sogar von mindestens 1500 V bereitgestellt werden. Beispielsweise ein Bauelement gemäß Fig. 2 mit einer Oxiddicke von insgesamt 680 nm und einer Nitriddicke von insgesamt 1000 nm kann bei 10 mA eine Durchbruchspannung von 1500 V erzielt werden.

Ob ein Si-RC Snubber-Bauelement mit einem der hierin beschriebenen Verfahren 100 hergestellt wurde, kann durch eine FIB-Querschnittsanalyse (Focused Ion Beam mit REM-Bildgebung) herausgefunden werden. Das Leckstromverhalten bei Nennspannung kann auf die Qualität des genutzten Oxids, d.h. der Siliziumdioxidschichten 220, hindeuten, hier kann zwischen PECVD-, nasschemisch gewachsen und trockenchemisch gewachsenen Oxiden grob unterschieden werden (abnehmender Leckstrom von PECVD- zu Nass- zu Trockenoxid). Ferner können TEM-Analysen zur Untersuchung der genutzten Oxidschichterzeugung (Abscheidung vs. Wachstum) genutzt werden. Eine weitere Möglichkeit besteht darin Ätzratenunterschiede der erzeugten Oxidschichten zu untersuchen.

Mit den hierin beschriebenen Verfahren können Snubberbauelemente zur Überspannungsbedämpfung in Leistungsmodulen hergestellt werden. Mit den Snubberbauelementen können z.B. Siliziumkarbidtransistoren in herkömmlichen Leistungsmodulen schneller geschaltet werden, ohne dass modulbedingte Induktion zu hohen Spannungsspitzen führt, welche potenziell Schädlich für alle Bauelemente im Modul sein könnten. Der Kondensator nimmt hier die Energie (in mehreren Zyklen) auf und über den integrierten Widerstand wird diese Energie in Wärme umgewandelt und dissipiert. Mögliche Anwendungsgebiete solcher Module sind z.B. die Fahrzeugelektronik (im Lademodul oder Antriebsstrang der E-Mobilität) oder bei erneuerbaren Energien (Windkrafträder, o.Ä.). Durch die Möglichkeit des schnelleren Schaltens kann die gesamte Effizienz der Leistungsmodule gesteigert werden, da weniger Verlustleistungen entstehen.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder eine elektronische Schaltung ausgeführt werden. Bei einigen Ausführungsbeispielen können einige oder mehrere der wichtigsten Verfahrensschritte durch einen solchen Apparat ausgeführt werden.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Verfahren (100) zur Herstellung einer Grabenkondensatorstruktur (200) umfassend die Schritte:
Bereitstellen (110) eines Siliziumsubstrats (210) mit einer Grabenstruktur mit einer Mehrzahl von Vertiefungen (212) in einer Hauptoberfläche (214) des Siliziumsubstrats (210);
Bilden (120) einer ersten Siliziumdioxidschicht (220₁) zumindest in den Vertiefungen (212) des Siliziumsubstrats (210);
Aufbringen (130) einer ersten Siliziumnitridschicht (230₁) auf der ersten Siliziumdioxidschicht (220₁);
Aufbringen (140) einer zweiten Siliziumdioxidschicht (220₂) auf der ersten Siliziumnitridschicht (230₁) durch Aufbringen (142) einer polykristalinen Siliziumschicht (222) und Oxidieren (144) der polykristalinen Siliziumschicht (222); und
Aufbringen (150) einer zweiten Siliziumnitridschicht (230₂) auf der zweiten Siliziumdioxidschicht (220₂).

2. Verfahren (100) gemäß Anspruch 1, wobei bei dem Oxidieren (144) der polykristalinen Siliziumschicht (222) eine Oxinitridschicht (232) zwischen der ersten Siliziumnitridschicht (230₁) und der zweiten Siliziumdioxidschicht (220₂) gebildet wird.

3. Verfahren (100) gemäß Anspruch 1, wobei bei dem Oxidieren (144) der polykristalinen Siliziumschicht (222) die polykristaline Siliziumschicht (222) vollständig in die zweite Siliziumdioxidschicht (220₂) umgewandelt wird.

4. Verfahren (100) gemäß Anspruch 3, wobei das Oxidieren (144), nachdem die polykristaline Siliziumschicht (222) vollständig in die zweite Siliziumdioxidschicht (220₂) umgewandelt wurde, weitergeführt wird, um die erste Siliziumnitridschicht (230₁) teilweise zu oxidieren und eine Oxinitridschicht (232) zwischen der ersten Siliziumnitridschicht (230₁) und der zweiten Siliziumdioxidschicht (220₂) zu bilden.

5. Verfahren (100) gemäß einem der vorrangehenden Ansprüche, wobei die polykristaline Siliziumschicht (222) undotiert ist.

6. Verfahren (100) gemäß einem der vorrangehenden Ansprüche, wobei die polykristaline Siliziumschicht (222) mittels Niederdruck-Gasphasenabscheidung auf der ersten Siliziumnitridschicht (230₁) aufgebracht wird.

7. Verfahren (100) gemäß einem der vorrangehenden Ansprüche, wobei die erste Siliziumdioxidschicht (220₁), die erste Siliziumnitridschicht (230₁), die zweite Siliziumdioxidschicht (220₂) und die zweite Siliziumnitridschicht (230₂) mit einer jeweiligen Schichtdicke in einem Bereich von 100 nm bis 1000 nm aufgebracht werden.

8. Verfahren (100) gemäß einem der vorrangehenden Ansprüche, wobei
das Bilden (120) der ersten Siliziumdioxidschicht (220₁) zumindest in den Vertiefungen (212) des Siliziumsubstrats (210) mittels thermischem Wachsen erfolgt;
das Aufbringen (130) der ersten Siliziumnitridschicht (230₁) auf der ersten Siliziumdioxidschicht (220₁) mittels Niederdruck-Gasphasenabscheidung erfolgt; und
das Aufbringen (150) der zweiten Siliziumnitridschicht (230₂) auf der zweiten Siliziumdioxidschicht (220₂) mittels Niederdruck-Gasphasenabscheidung erfolgt.

9. Verfahren (100) gemäß einem der vorrangehenden Ansprüche, wobei eine Siliziumnitridschicht (230) auf einer Siliziumdioxidschicht (220) ein Schichtpaar (242) bilden,
wobei die erste Siliziumdioxidschicht (220₁) und die erste Siliziumnitridschicht (230₁) ein erstes Schichtpaar (242₁) bilden und die zweite Siliziumdioxidschicht (220₂) und die zweite Siliziumnitridschicht (230₂) ein zweites Schichtpaar (242₂) bilden, wobei auf dem zweiten Schichtpaar (242₂) zumindest ein weiteres Schichtpaar (242) aufgebracht wird, und
wobei ab dem zweiten Schichtpaar (242₂) die jeweilige Siliziumdioxidschicht (220) durch Aufbringen (142) einer polykristalinen Siliziumschicht (222) und Oxidieren (144) der polykristalinen Siliziumschicht (222) aufgebracht wird.

10. Verfahren (100) gemäß Anspruch 9, wobei auf dem zweiten Schichtpaar (242₂) das zumindest eine weitere Schichtpaar (242) so aufgebracht wird, dass eine Schichtstruktur mit abwechselnden Siliziumdioxid- und Siliziumnitridschichten gebildet wird.

11. Verfahren (100) gemäß einem der vorrangehenden Ansprüche, wobei das Oxidieren (144) der polykristalinen Siliziumschicht (222) mittels trockenchemischer Oxidation oder nasschemischer Oxidation erfolgt.

12. Verfahren (100) gemäß einem der vorrangehenden Ansprüche zur Bildung eines RC-Snubberelements (300).

13. Grabenkondensator umfassend
eine Dielektrikumschichtstruktur (240) mit einer ersten Siliziumdioxidschicht (220₁), einer ersten Siliziumnitridschicht (230₁), einer zweiten Siliziumdioxidschicht (220₂) und einer zweiten Siliziumnitridschicht (230₂);
wobei die erste Siliziumdioxidschicht (220₁), die erste Siliziumnitridschicht (230₁), die zweite Siliziumdioxidschicht (220₂) und die zweite Siliziumnitridschicht (230₂) in dieser Reihenfolge aneinandergrenzen.

14. Grabenkondensator gemäß Anspruch 13, wobei eine Schichtdicke der ersten Siliziumdioxidschicht (220₁), der ersten Siliziumnitridschicht (230₁), der zweiten Siliziumdioxidschicht (220₂) und der zweiten Siliziumnitridschicht (230₂) in einem Bereich von 100 nm bis 1000 nm liegt.

15. Grabenkondensator gemäß Anspruch 13 oder Anspruch 14, wobei der Grabenkondensator mittels des Verfahrens (100) nach einem der Ansprüche 1 bis 12 hergestellt ist.
